# EUROPEAN PATENT APPLICATION

(11) **EP 2 076 107 A2**
(43) Date of publication of application: **01.07.2009**
(21) Application number: 08254022.0
(22) Date of filing: 16.12.2008
(51) Int. Cl.: H05K 5/02

(54) **Display device**

(30) Priority: 28.12.2007 JP 2007339297
(71) Applicant: Orion Electric Co., Ltd, Echizen-shi, Fukui 915-8555 (JP)
(72) Inventor: Yusuke, Kataoka, Echizen-shi, Fukui 915-8555 (JP); Hidenobu, Mukougawa, Echizen-shi, Fukui 915-8555 (JP); Masahide, Moroishi, Echizen-shi, Fukui 915-8555 (JP); Seigo, Ohkubo, Echizen-shi, Fukui 915-8555 (JP); Shinichi, Tanikawa, Echizen-shi, Fukui 915-8555 (JP); Takanori, Maeno, Echizen-shi, Fukui 915-8555 (JP); Yoshikazu, Saga, Echizen-shi, Fukui 915-8555 (JP); Kenji, Tsubota, Echizen-shi, Fukui 915-8555 (JP); Tamotsu, Mitamura, Echizen-shi, Fukui 915-8555 (JP)
(74) Representative: Paget, Hugh Charles Edward

(57) **Abstract**

The present invention provides a display device that facilitates product inspection and maintenance. A button section 4 is mounted to a back cabinet 2b, and a power-source circuit board 5a is fitted into a circuit-board fitting slit 30. Furthermore, the power-source circuit board 5a is locked and fixed by a first circuit-board locking claw 31, and a main circuit board 5b is locked and fixed by a second circuit-board locking claw 32. A speaker 6 integrally assembled in a speaker holder 34 is locked and fixed by a speaker locking claw 36, and thereafter a display panel 3 is caused to be held by a display panel standing holding portion 45 in a standing manner. The wire connection work of a display panel 3, each of the circuit boards, and the like is performed, the display panel 3 is brought down and placed on a display panel placement portion 44, a front cabinet 2a is mounted, and a leg portion 9 is mounted to a leg-portion mounting portion 51.

## Description

### BACKGROUND OF THE INVENTION

### Field of the Invention

The present invention relates to a display device having high workability in manufacture and maintenance.

### Description of the Related Art

Thin-screen display devices have predominant market shares in recent display devices, and the percentage of thin-screen display devices has been increasing year by year. Because thin-screen display devices are very thin compared to conventional display devices, a large number of electronic parts are incorporated at high densities. Therefore, it is necessary to perform shielding strictly in order to prevent noises generated from circuit boards and electronic parts from affecting other circuit boards.

For example, in a liquid-crystal display panel used in a pachinko board where electronic parts are densely packed (pachinko is a Japanese vertical pinball game), Japanese Patent Laid-Open Publication No. 6-252567 discloses a liquid-crystal display device which is constructed in such a manner that, in order to prevent noises generated by the liquid-crystal display panel from affecting surrounding pieces of electronic equipment, the liquid-crystal display panel, input and output circuits and other circuit boards are housed in a back-side shield member, a front-side shield member and a front frame are mounted to the back-side shield member, and a back frame is further mounted.

Japanese Utility Model Registration Publication No. 3127049 discloses a display device in which materials mainly composed of magnesium alloys/aluminum alloys are used as a display housing having good radiating properties and electromagnetic wave shielding properties.

Although the method of Japanese Patent Laid-Open Publication No. 6-252567 is readily applied to small display devices in which electronic parts are densely packed in a surrounding manner, the sizes of the shield members become large when this method is applied to relatively large display devices, such as television receiving sets and personal computers used in general households, and it is difficult to avoid rises in manufacturing costs and increases in weight. Also in the method of Japanese Utility Model Registration Publication No. 3127049, rises in manufacturing costs and increases in weight occur similarly due to the increase in the sizes of the shield members.

In the construction of Japanese Patent Laid-Open Publication No. 6-252567, the display panel and various circuit boards are housed in the front frame and the back-side shield member and thereafter the back frame is mounted. Therefore, during the performance inspection and maintenance of products, when the circuit boards and the like are checked, it is necessary to detach the front frame and the back frame, and furthermore the back-side shield member, thereby making the work complicated.

### SUMMARY OF THE INVENTION

The present invention has been made in view of the above-described problems, and has as it object the provision of a display device that facilitates product inspection and maintenance and enables shield members to be appropriately applied in places where noises are generated.

The display device related to a first aspect of the present invention is a display device that is provided with internal component parts and a display panel within a cabinet formed by assembling an opening of a front cabinet and an opening of a back cabinet. In this display device, within the back cabinet, a mounting portion for mounting an operation button as one of the internal component parts, a mounting portion for mounting a circuit board as one of the internal component parts, a mounting portion for mounting a speaker for audio output as one of the internal component parts, and a mounting portion for mounting a recording and reproducing device as one of the internal component parts are formed each with respect to the back cabinet. And in this display device, a placement portion for placing the display panel is integrally formed as a boss from the back cabinet.

According to the construction of the display device in the above first aspect, it is possible to mount the operation button, circuit board, speaker for audio output and recording and reproducing device, which are the internal component parts, within the back cabinet, the display panel can be placed, and it becomes possible to perform the manufacturing work and maintenance work, such as the mounting of all parts, from the opening side of the back cabinet.

The display device related to a second aspect of the present invention is a display device that is provided with internal component parts and a display panel within a cabinet formed by assembling an opening of a front cabinet and an opening of a back cabinet. In this display device, within the back cabinet, a mounting portion for mounting an operation button as one of the internal component parts, a mounting portion for mounting a circuit board as one of the internal component parts, and a mounting portion for mounting a speaker for audio output as one of the internal component parts are formed each with respect to the back cabinet. In this display device, a placement portion for placing the display panel is integrally formed as a boss from the back cabinet. And in this display device, a display panel standing holding portion for holding the display panel placed on the placement portion in a standing manner is provided.

According to the construction of the display device in the above second aspect, it is possible to mount the operation button, circuit board and speaker for audio output, which are the internal component parts, within the back cabinet, and it is possible to hold the display panel by causing the standing holding portion to temporarily stand the display panel. Therefore, it becomes possible to perform the manufacturing work and maintenance work, such as the mounting of all parts, from the opening side of the back cabinet, and furthermore, the connection work of the display panel and the circuit board and the like becomes easy.

The display device related to a third aspect of the present invention is a display device that is provided with internal component parts and a display panel within a cabinet formed by assembling an opening of a front cabinet and an opening of a back cabinet. In this display device, within the back cabinet, a mounting portion for mounting an operation button as one of the internal component parts, a mounting portion for mounting a circuit board as one of the internal component parts, a mounting portion for mounting a speaker for audio output as one of the internal component parts, and a mounting portion for mounting a recording and reproducing device as one of the internal component parts are formed each with respect to the back cabinet. In this display device, a placement portion for placing the display panel is integrally formed as a boss from the back cabinet. And a display panel standing holding portion for holding the display panel placed on the placement portion in a standing manner is provided.

According to the construction of the display device in the above third aspect, it is possible to mount the operation button, circuit board, speaker for audio output and recording and reproducing device, which are the internal component parts, within the back cabinet, and it is possible to hold the display panel by causing the standing holding portion to temporarily stand the display panel. Therefore, it becomes possible to perform the manufacturing work and maintenance work, such as the mounting of all parts, from the opening side of the back cabinet, and furthermore, the connection work of the display panel and the circuit board and the like becomes easy.

The display device related to a fourth aspect of the present invention is such that in the display device in any one of the first to third aspects, a back surface of the display panel is formed from a metal plate, a grounding member having a plate spring portion is mounted to the circuit board, and the plate spring portion of the grounding member comes into contact with the back surface of the display panel when the display panel is placed on the placement portion.

According to the construction of the display device in the above fourth aspect, the display panel is placed on the back cabinet, whereby it is possible to perform grounding by the contact between the metal plate on the back surface of the display panel and the grounding member and hence it becomes unnecessary to perform wire connection for grounding.

The display device related to a fifth aspect of the present invention is such that in the display device in any one of the first to fourth aspects, a shield member is mounted in places of the circuit board where noises are generated, whereby the effect of noises by the circuit board is suppressed.

According to the construction of the display device in the above fifth aspect, the display panel is placed on the back cabinet by using, for example, a shield member whose width is wider than the width of a connection cable from which noises are generated, whereby the connection cable can be effectively shielded by being sandwiched between the shield member and the metal plate on the back surface of the display panel.

### BRIEF DESCRIPTION OF THE DRAWINGS

FIG. 1 is a perspective view of a display device, which is a video display device, in an embodiment of the present invention;
FIG. 2 is an exploded perspective view of the display device shown in FIG. 1, in which a front cabinet of the display device is detached;
FIG. 3 is a perspective view of the display device shown in FIG. 1, in which a display panel is detached from a back cabinet;
FIG. 4 is a perspective view of an operation section
in which a button section and a fixing unit are integrated in the display device shown in FIG. 1;
FIG. 5 is a perspective view of the button section in the display device shown in FIG. 1;
FIG. 6 is a perspective view of the fixing unit in the display device shown in FIG. 1;
FIG. 7 is an enlarged sectional view showing essential parts of the display device shown in FIG. 1;
FIG. 8 is an exploded perspective view of speakers and speaker holders to which the speakers are attached in the display device shown in FIG. 1;
FIG. 9 is a perspective view showing the speakers attached to the speaker holders in the display device shown in FIG. 1;
FIG. 10 is a perspective view of a shield member in the display device shown in FIG. 1;
FIG. 11 is a perspective view of a grounding member in the display device shown in FIG. 1;
FIG. 12 is a perspective view of a leg portion in the display device shown in FIG. 1;
FIG. 13 is a perspective view of a back cabinet in the display device shown in FIG. 1;
FIG. 14 is a perspective view showing the button section assembled to the back cabinet by use of the fixing unit in the display device shown in FIG. 1;
FIG. 15 is a perspective view showing circuit boards assembled to the back cabinet in the display device shown in FIG. 1;
FIG. 16 is a perspective view showing the speaker assembled to the back cabinet in the display device shown in FIG. 1;
FIG. 17 is perspective view of a display panel held in a standing manner on the back cabinet in the display device shown in FIG. 1;
FIG. 18 is an enlarged sectional view of a display panel standing holding portion in the display device shown in FIG. 1;
FIG. 19 is a sectional view showing the condition of the front cabinet and the back cabinet, which are assembled, in the display device shown in FIG. 1;
FIG. 20 is an enlarged perspective view showing the area around a leg-portion mounting portion of the back cabinet in the display device shown in FIG. 1;
FIG. 21 is an exploded perspective view showing the condition before the mounting of the leg portion to a cabinet in the display device shown in FIG. 1; and
FIG. 22 is an enlarged perspective view showing an example in which a temporary holding portion has a different shape.

### DETAILED DESCRIPTION OF THE PREFERRED EMBODIMENTS

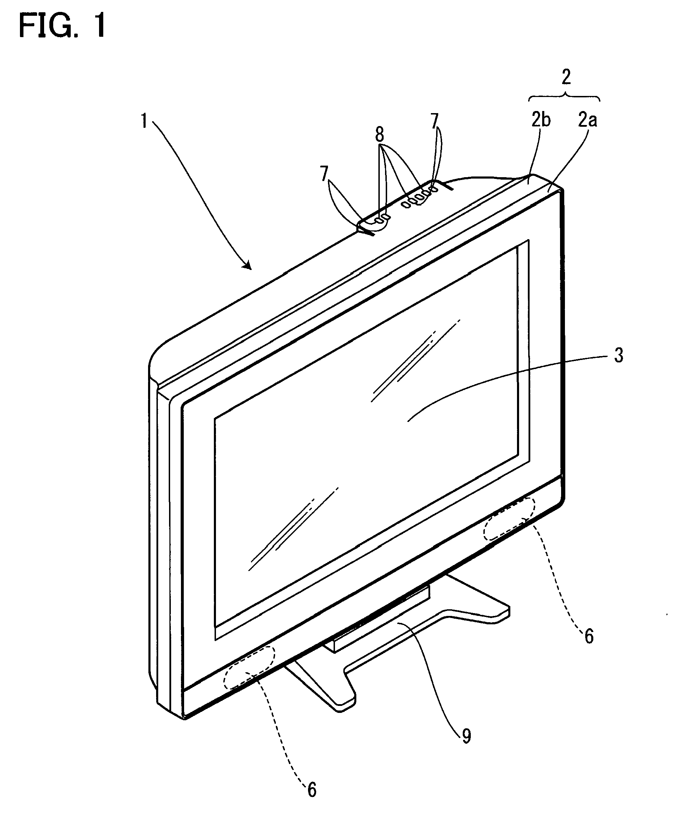

A preferred embodiment for carrying out the present invention will be described below with reference to FIGS. 1 to 14. Of course, it is needless to say that the present invention can be readily applied to embodiments of other constitutions other than those described in the embodiment so long as these do not depart from the gist of the present invention.

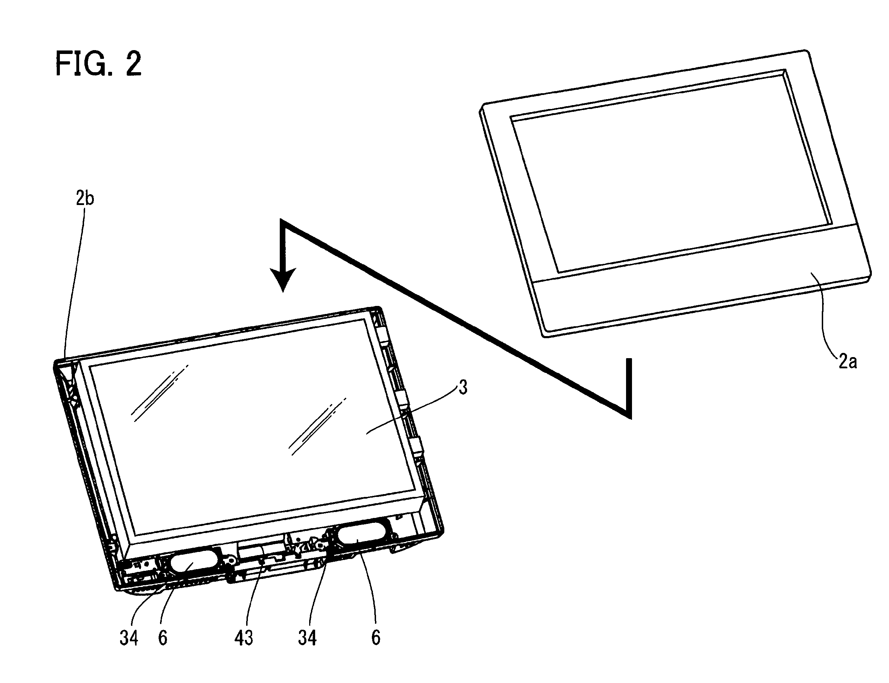

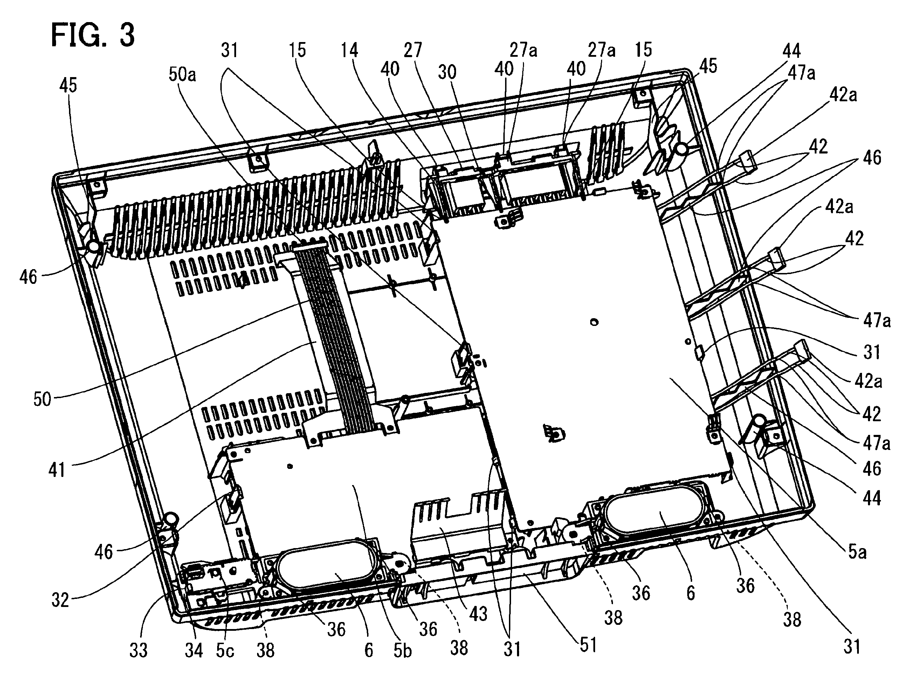

FIG. 1 is a perspective view of a video display device in an embodiment of the present invention. FIG. 2 is an exploded perspective view of the video display device, in which a front cabinet of the video display device is removed. FIG. 3 is a perspective view of the video display device, in which a display panel is removed from a back cabinet.

An example of a display device shown in FIGS. 1 to 3 is a display device 1, such as a thin-screen liquid-crystal television receiving set having a small depth dimension. A resin cabinet 2 that forms the appearance of the display device 1 is composed of a front cabinet 2a and a back cabinet 2b in a two-divided manner, and a display panel 3, which is a liquid-crystal panel displaying video images, and internal component parts, such as a button section 4, various kinds of circuit boards 5a, 5b, 5c arranged substantially parallel to the display panel 3, and speakers 6 are all housed in the back cabinet 2b, and not in the front cabinet 2a. Through holes 7 are formed on a top surface of the back cabinet 2b, and buttons 8 formed on a button section 4 are inserted into the through holes 7 and disposed so as to protrude upward to the outside of the back cabinet 2b. The front cabinet 2a and the back cabinet 2b are assembled together as a unit, with openings, which are provided in the cabinets, opposed to each other, and the interiors of the cabinet 2 have a small depth dimension compared to the height and width dimensions thereof. Incidentally, the cabinet 2 can be placed on a flat surface of a desk or the like in a standing manner by use of a leg portion 9.

Display-panel standing holding portions 45 are formed in upward edge parts of the interior of the back cabinet 2b. In the display panel standing holding portion 45, there are formed a display panel standing placement portion 45a for placing the display panel 3 in a standing manner, and display panel supporting pieces 45b, 45c for supporting the display panel 3 placed on the display panel standing placement portion 45a. Furthermore, as positioning means for placing the display panel 3 on the back cabinet 2b and housing the display panel 3 in obtaining a product as an assemblage, display panel placement portions 44 are integrally formed as bosses, and the display panel placement portions 44 serve to increase the strength of the display panel standing holding portion 45. A leg mounting portion 51 for mounting the leg portion 9 is provided in the back cabinet 2b.

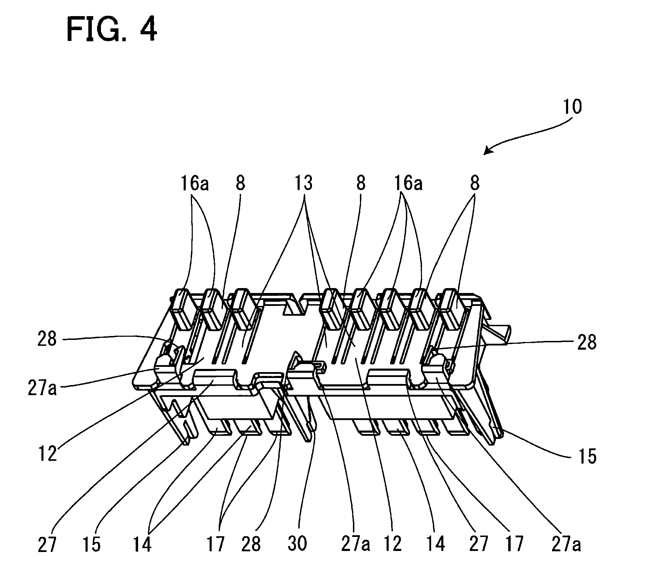

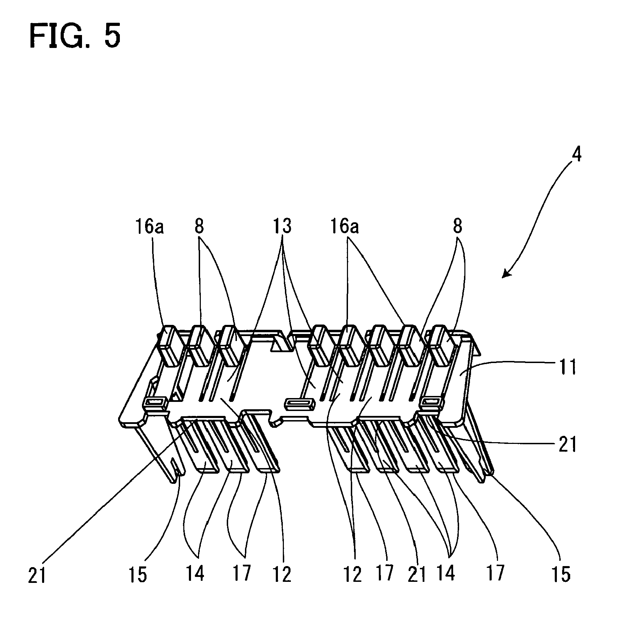

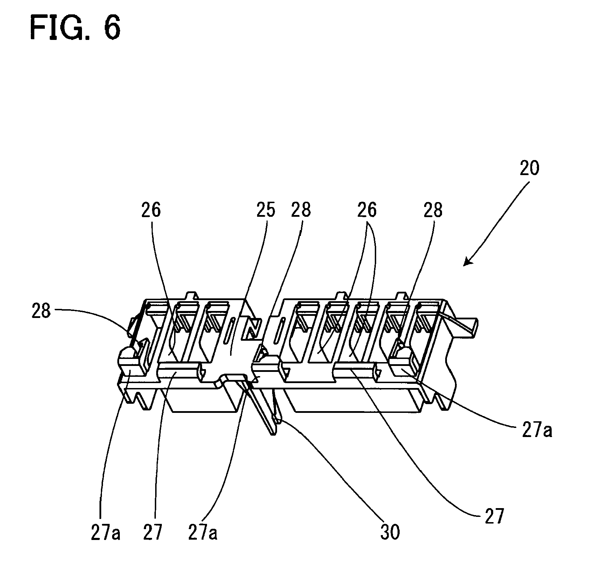

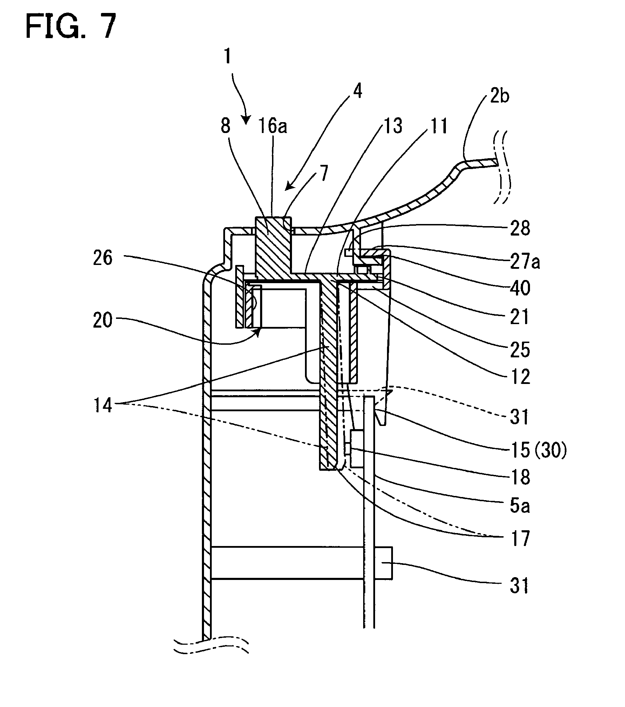

Next, a description will be given of the button section 4 and the fixing unit 20 used to fix this button section 4 to the back cabinet 2b. FIG. 4 is a perspective view of an operation section in which the button section and the fixing unit are integrated. FIG. 5 is a perspective view of the button section. FIG. 6 is a perspective view of the fixing unit. FIG. 7 is an enlarged sectional view showing essential parts of the display device.

As shown in FIGS. 4 to 7, the button section 4 is attached, with the buttons 8 protruding from the through holes 7 formed in the back cabinet 2b to the upward outer side of the cabinet 2 as described above. The whole button section 4 is made of synthetic resin, and is integrally composed of a frame portion 11 in the form of a flat plate, hinged portions 13 that are caused to tilt using supporting point portions 12 as supporting points, the above-described buttons 8 provided at the forward ends of the hinged portions 13, operation protrusions 14 integrally provided in the vicinity of the supporting point portions 12 of the hinged portions 13, circuit-board fitting slits 15, which are guide grooves supporting the power-source circuit board 5a in a sandwiching manner, which will be described later, and the like. As shown in FIG. 7, with the button section 4 assembled to the back cabinet 2b, manual operation is performed by depressing a forward end 16a of the button 8 with the finger or the like, whereby a switch contact portion 17 of the operation protrusion 14, which is positioned on the other side, is caused to tilt using the supporting point portion 12 as a supporting point, the switch contact portion 17 of the operation protrusion 14 depresses the switch 18 mounted on the power-source circuit board 5a, with the result that the on-off switching operation of the switch 18 is continuously performed.

In the button section 4, a plurality of concavities 21 for integrally assembling the button section 4 to the fixing unit 20 are formed in the side edge portions in a stepped manner, and when a locking claw for button-section fixing 27 formed in the fixing unit 20, which will be described later, is caused to engage with the above-described concavity 21, the button section 4 and the fixing unit 20 are mutually positioned and integrated together and an operation section 10 composed of the button section 4 and the fixing unit 20 is integrally formed.

Next, the construction of the fixing unit 20 will be described. This fixing unit 20 is intended for fixing the button section 4 to the back cabinet 2b, and as with the above-described button section 4, the whole fixing unit 20 is made of synthetic resin. The fixing unit 20 is integrally composed of a housing 25 that is caused to abut against a frame portion 11 of the button section 4, button-housing holes 26 that are formed in a number corresponding to the number of the operation protrusions 14 of the button section 4, the L-shaped locking claws for button-section fixing 27, which are caused to engage with the stepped concavities 21 of the button section 4, L-shaped locking claws for cabinet fixing 27a, which are formed integrally with the housing 25, key-shaped locking stopper 28, which are integrally formed on side portions of the locking claws for cabinet fixing 27a, circuit-board fitting slits 30, which are guide grooves supporting the power-source circuit board 5a in a sandwiching manner, and the like.

Next, on the basis of FIG. 3 a description will be given of the various circuit boards 5a to 5c assembled within the back cabinet 2b. The above-described power-source circuit board 5a constitutes a circuit of a power-source system of the display device 1, and the power-source circuit board 5a is caused to be supported in a sandwiched manner in the circuit-board fitting slits 15, 30, which are formed in the button section 4 and the fixing unit 20, and a plurality of first circuit-board locking claws 31 formed in the back cabinet 2b are caused to be locked to edge portions of the power-source circuit board 5a, whereby the power-source circuit board 5a is firmly fixed to the back cabinet 2b (the condition shown in FIG. 7). Incidentally, the above-described circuit-board fitting slits 15, 30, which are guide grooves, are formed so as to extend in the rear of the operation section 10. In the power-source circuit board 5a, connection cables 42 for supplying power to the display panel 3 are provided in pairs in an extended condition, and a connector 42a for connection to a connector 49 of the display panel 3 is formed at a forward end of the connection cables 42 that constitute a pair.

The main circuit board 5b constitutes a circuit for performing the control of the whole display device 1. Second circuit-board locking claws 32 formed in the back cabinet 2b, which are holding means (locking means), are locked to peripheral edge portions of the main circuit board 5b, whereby the main circuit board 5b is firmly fixed to the back cabinet 2b. A video signal transmission cable 50 for transmitting video signals to the display panel 3 is provided in an extended condition to the main circuit board 5b, and the video signal transmission cable 50 is provided, at the forward end thereof, with a connector 50a for connection to a connector 54 of the display panel 3. The main circuit board 5b is provided with a shield member 41 for shielding and absorbing noises generated by the video signal transmission cable 50. Furthermore, a grounding member 43 for grounding the main circuit board 5b is attached in the vicinity of the edge portion of the above-described main circuit board 5b.

The light-receiving board 5c provided with a light-receiving section is made up by a circuit that controls switching of channels of the display device 1 on the basis of signals sent from an unillustrated remote controller for remote control of the display device 1, and a peripheral edge portion of the light-receiving board 5c is locked and fixed to a light-receiving board locking claw 33 formed in a speaker holder (holder) fixed to the back cabinet 2b, which is locking means. Incidentally, though details are omitted because this is not the gist of the present invention, it is needless to say that various kinds of electronic parts, such as a CPU, which is control means, are mounted on each of the circuit boards 5a, 5b and 5c.

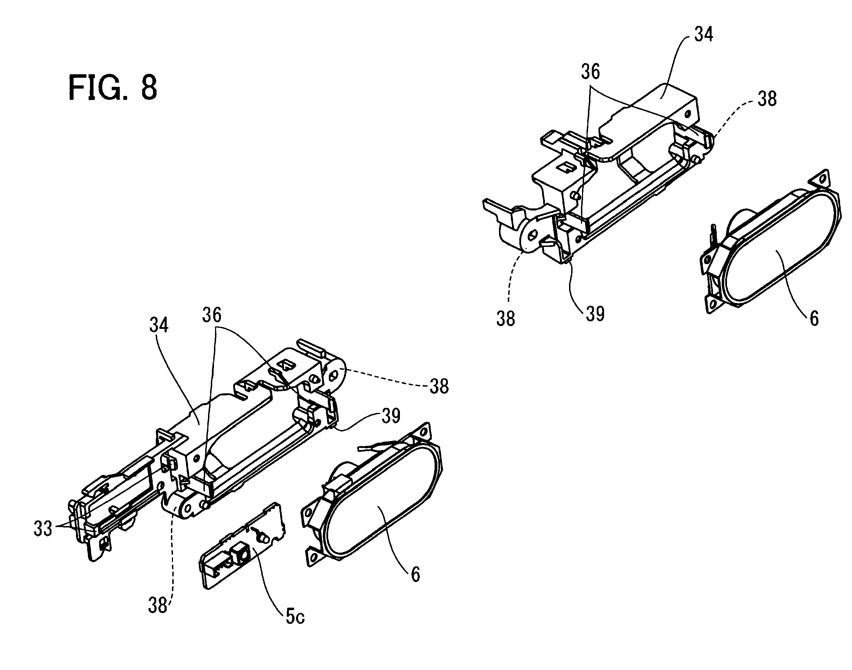

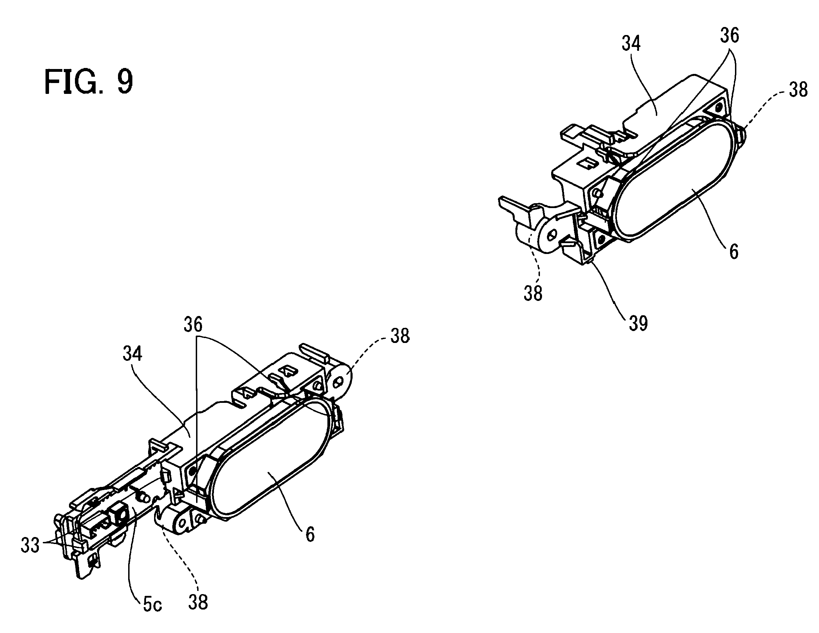

Next, with reference to FIGS. 8 and 9 a description will be given of a pair of speakers 6 that outputs sounds in response to video images displayed on the display panel 3. Incidentally, FIG. 8 is an exploded perspective view of speakers and speaker holders to which the speakers are attached, and FIG. 9 is a perspective view showing the speakers attached to the speaker holders. The speakers 6 shown in the figures are held by (fixed to) the back cabinet 2b via the speaker holders 34, each of the speaker holders 34 is provided with a pair of speaker locking claw 36 that fixes the right and left sides of each of the speakers 6. That is, the speaker holder 34 is provided with means for locking the speaker 6 in addition to the light-receiving board locking claw 33 for fixing the above-described light-receiving board 5c.

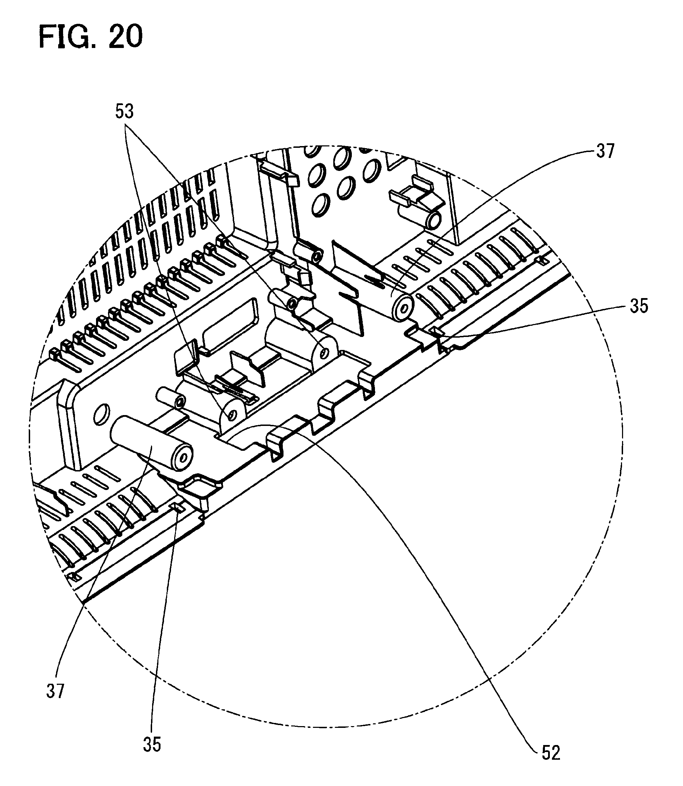

In the speaker holder 34, there are formed cylindrical holes 38 that are fitted onto cylindrical boss portions 37, which are formed integrally in the back cabinet 2b, and the speaker holder 34 is held by the back cabinet 2b by inserting the cylindrical holes 38 into the boss portions 37. Incidentally, as shown in FIG. 20, the boss portions 37 are formed so as to extend from the inner surface side of the back cabinet 2b to the opening side of the back cabinet 2b and furthermore, engagement holes 35 are formed in peripheral edge portions of the opening of the back cabinet 2b in the vicinity of the boss portions 37. A claw portion 39 formed in the speaker holder 34 is caused to engage with the engagement hole 35 and the boss portion 37 of the back cabinet 2b is fitted onto the cylindrical hole 38 formed in the speaker holder 34, whereby the speaker holder 34 is fixed to the back cabinet 2b.

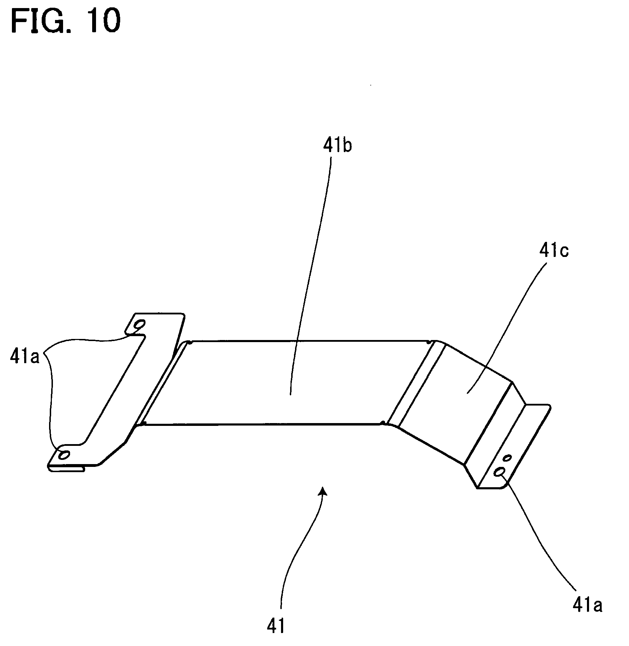

Next, on the basis of FIG. 10 a description will be given of the shield member 41 for suppressing the effect of noises generated when the display device 1 is brought into operation. This shield member 41 shields and decreases noises generated by the video signal transmission cable 50 that connects the main circuit board 5b and the display panel 3 and performs the transmission of video signals, which will be described later. In the shield member 41, mounting holes 41a for fixing the shield member 41 are formed. A shield portion 41b for shielding electronic parts and cables that generate noises from other circuits is formed. An inclined portion 41c is formed to cause the shield portion 41b to be disposed above the mounting position of the shield member 41 and to position the shield member 41 so as to bring a metal plate 48 covering a back surface of the display panel 3, which will be described later, and the video signal transmission cable 50 into contact with each other.

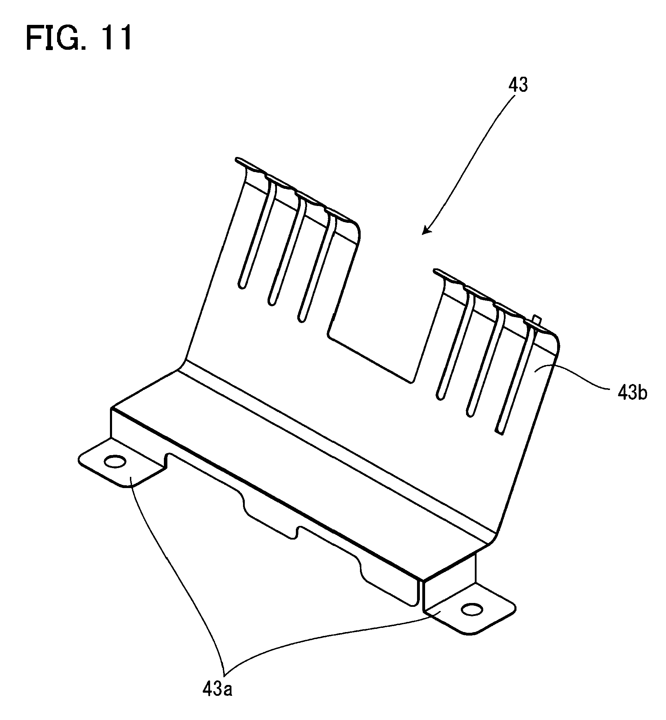

Next, on the basis of FIG. 11 a description will be given of a grounding member for grounding the electronic parts mounted on various kinds of circuit boards when the display device 1 is brought into operation. Reference numeral 43 denotes the grounding member. Reference numeral 43a denotes mounting holes that serve also as electrical connections for grounding various kinds of circuit boards, the main circuit board 5b in this embodiment. The grounding member 43 is fixed to the main circuit board 5b by using the mounting holes 43a. Reference numeral 43b denotes a plate spring portion. As shown in FIG. 11, the plate spring portion 43b is inclined upward, as a result of which, it is possible to perform grounding by establishing contact with the metal plate 48 covering the back surface of the display panel 3 placed on the back cabinet 2b.

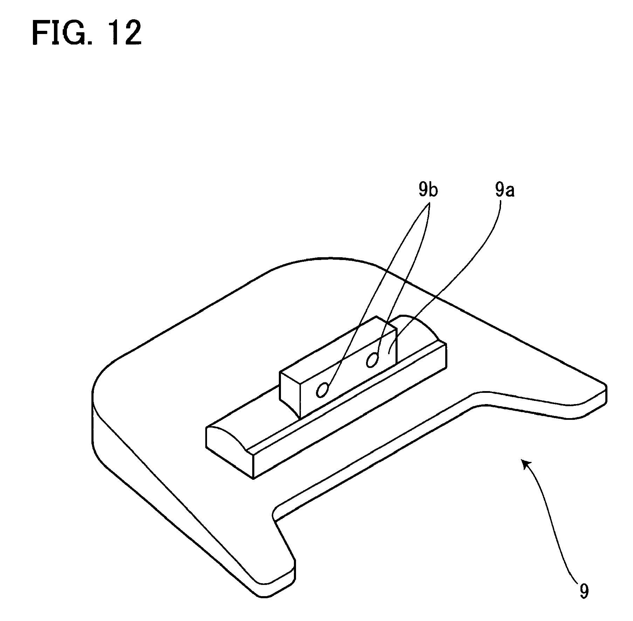

Next, on the basis of FIG. 12 a description will be given of the leg portion 9 for placing and supporting the display device 1. Reference numeral 9 denotes the leg portion. A convex mounting portion 9a is formed in the leg portion 9. This convex mounting portion 9a is intended for insertion into a leg-portion mounting hole 52 formed in a leg-portion mounting portion 51 formed in the back cabinet 2b, which will be described later. Screw holes 9b are formed in the mounting portion 9a. The leg portion 9 can be fixed by inserting unillustrated screws into the screw holes 9b via leg-portion mounting screw holes 53 provided in the back cabinet 2, which will be similarly described later.

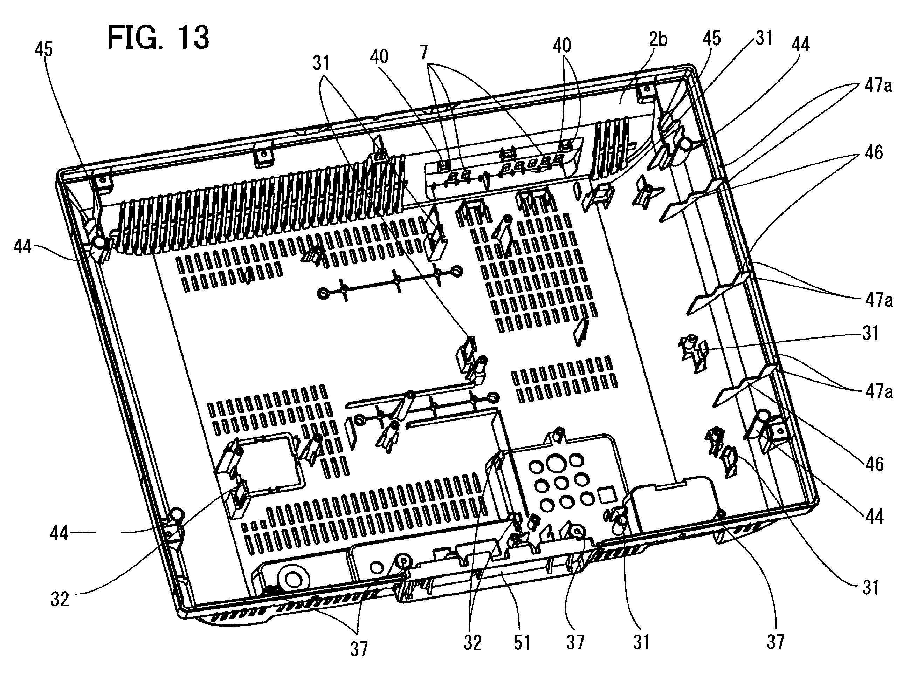

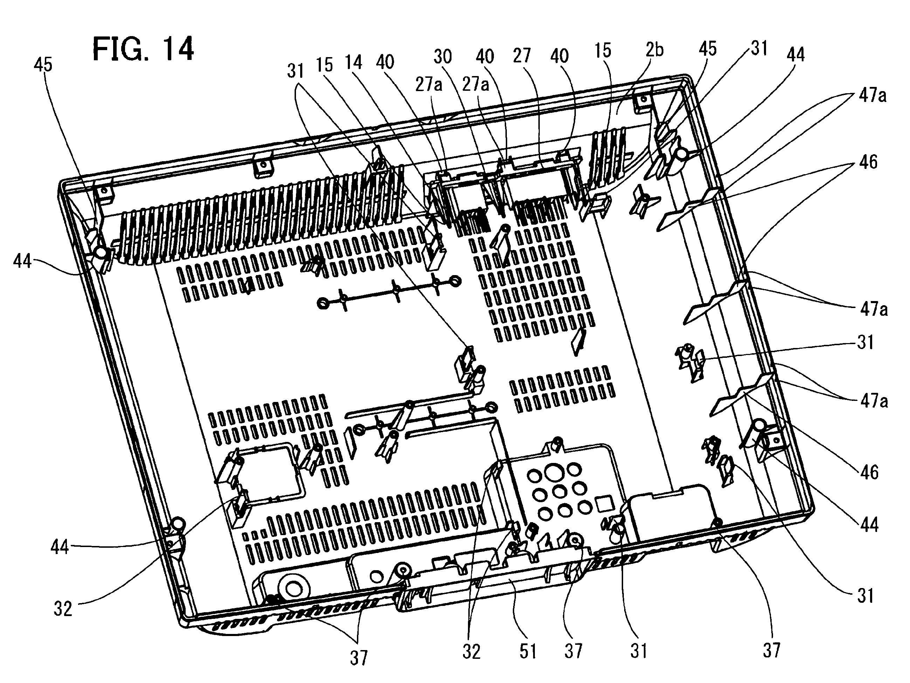

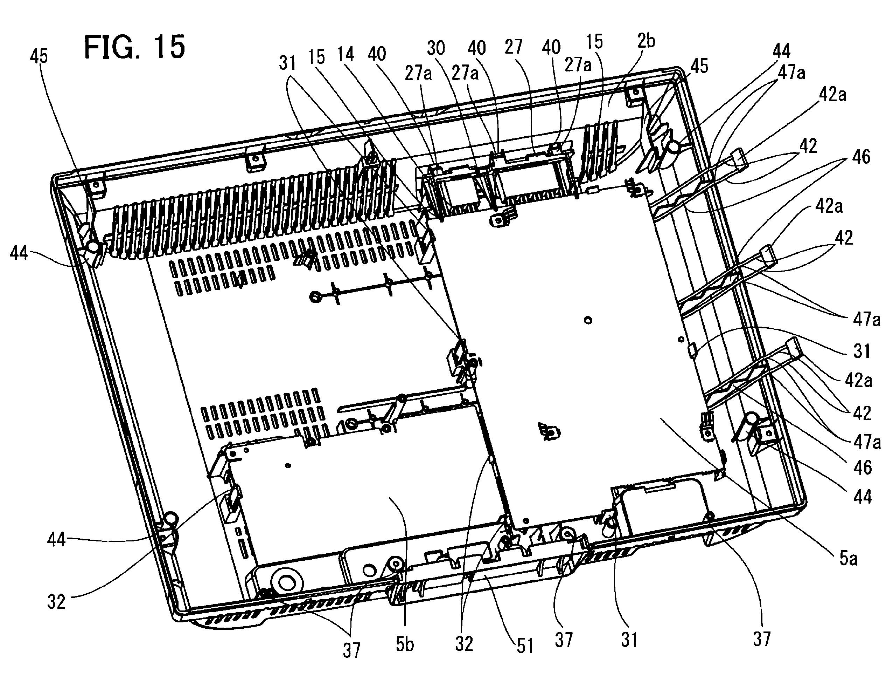

Next, on the basis of FIGS. 13 to 22 a description will be given of a procedure for assembling the button section 4, circuit boards 5a to 5c, and speaker 6, which are the main parts of the display device 1, to the back cabinet 2b. Incidentally, FIG. 13 is a perspective view of only the back cabinet. FIG. 14 is a perspective view showing the button section assembled to the back cabinet by use of the fixing unit. FIG. 15 is a perspective view showing the circuit boards assembled to the back cabinet.

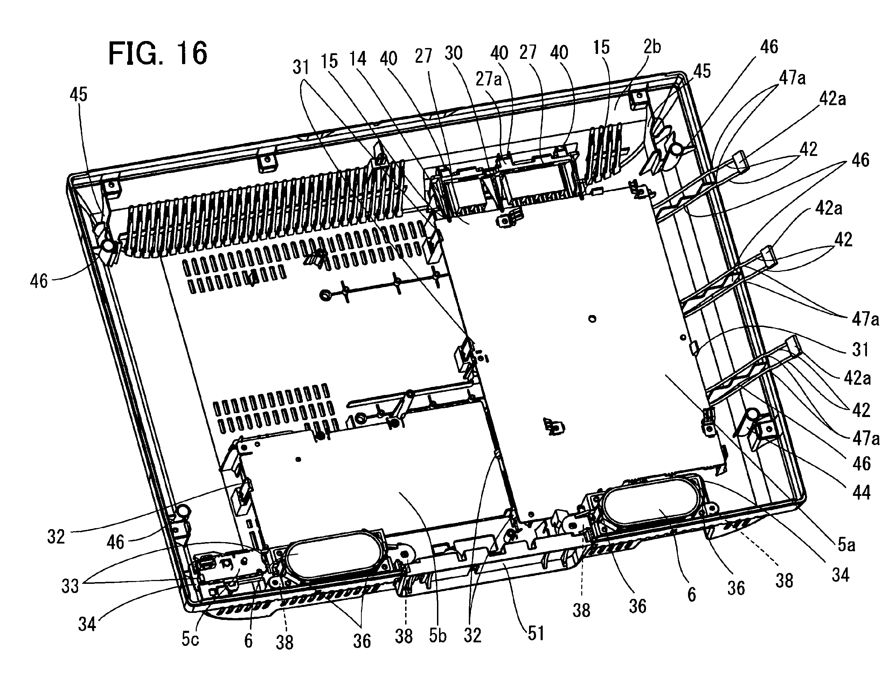

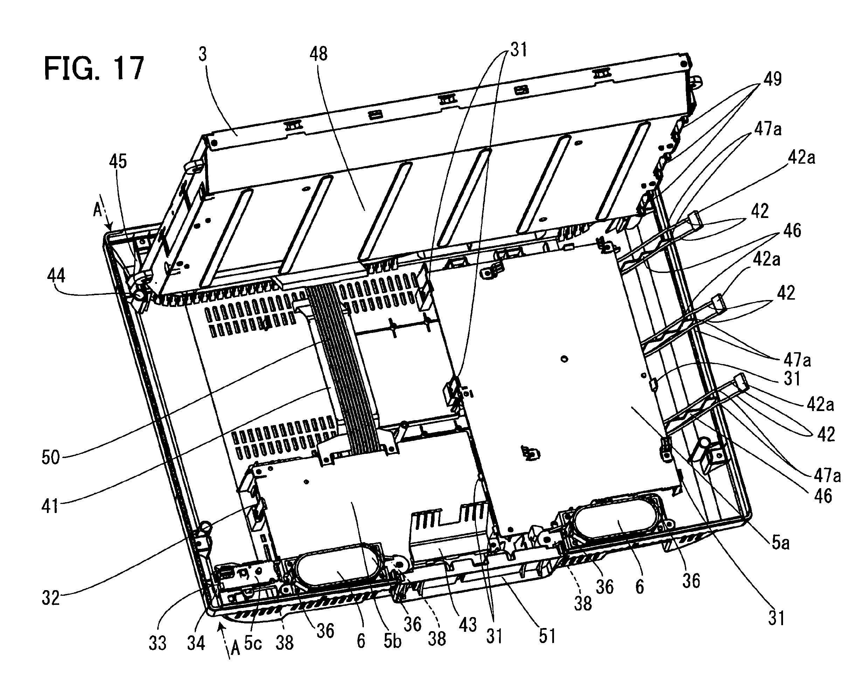

FIG. 16 is a perspective view showing the speaker assembled to the back cabinet. FIG. 17 is perspective view of the display panel held in a standing manner on the back cabinet.

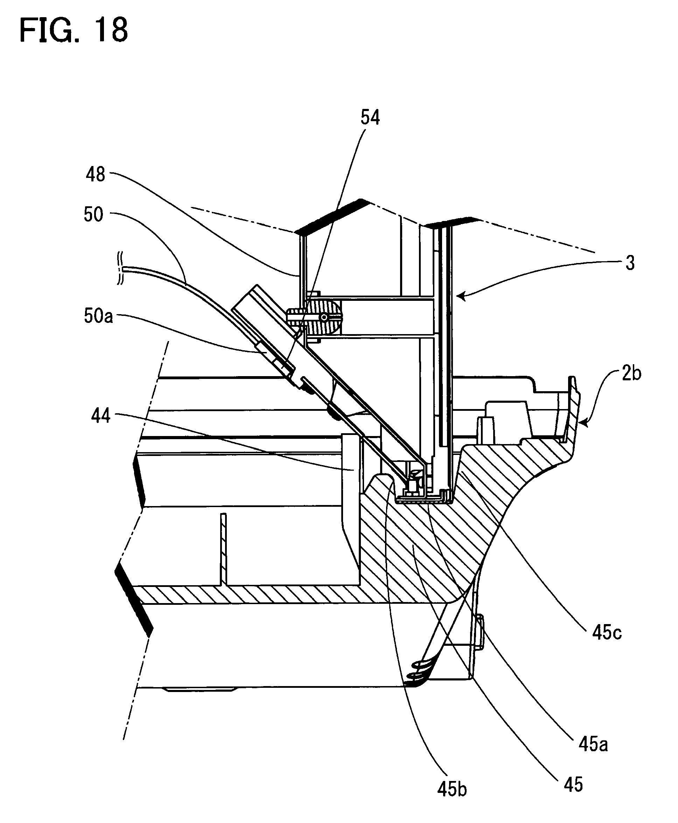

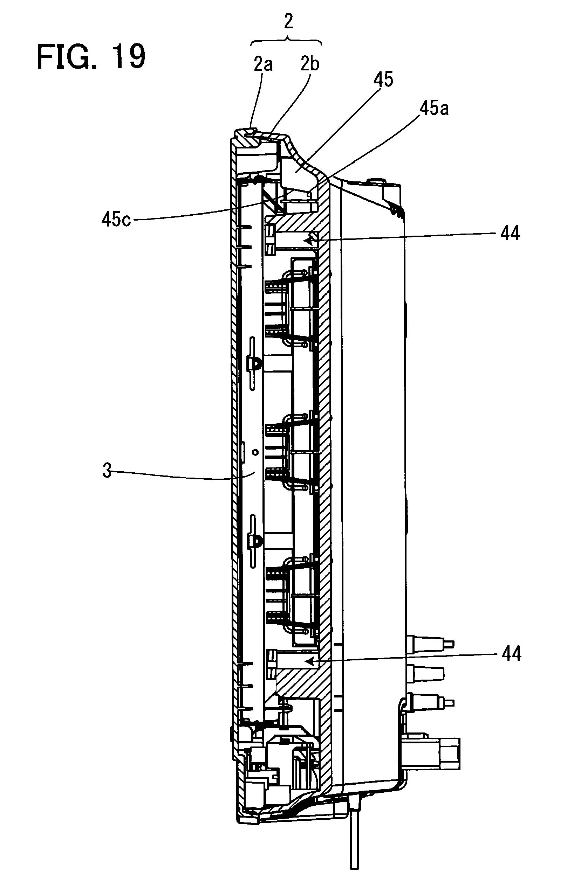

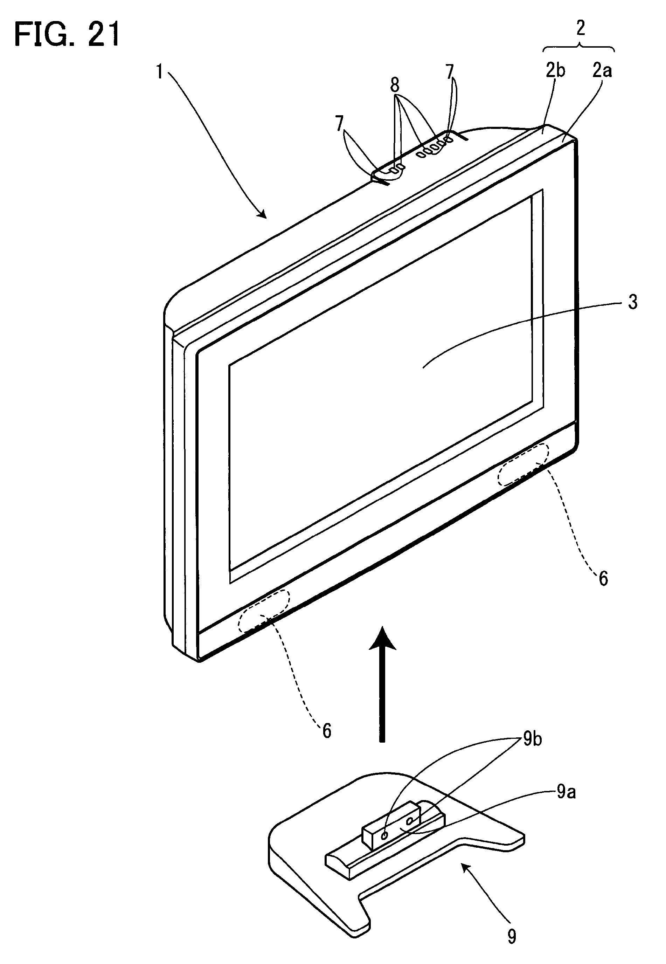

FIG. 18 is an enlarged sectional view showing the condition of the display panel standing holding portion when the display panel 3 is held in a standing manner. FIG. 19 is a sectional view showing the condition obtained when the display panel is placed on the display panel placement portion and the back cabinet and the front cabinet are assembled. FIG. 20 is a partial enlarged perspective view showing details of the shape of the leg-portion mounting portion of the back cabinet. And FIG. 21 is a perspective view showing the process of mounting the leg portion to the cabinet.

First, in order to integrate the button section 4 and the fixing unit 20, which are shown in FIGS. 5 and 6, the operation protrusions 14 of the button section 4 are inserted into the button-housing holes 26 of the fixing unit 20, and with the frame portion 11 of the button section 4 kept abutted against the housing 25 of the fixing unit 20, the locking claws for button-section fixing 27 of the fixing unit 20 are caused to engage with the concave portions 21 of the button section 4, whereby as shown in FIG. 4, the button section 4 and the fixing unit 20 are assembled together as a unit.

Subsequently, in order to fix the button section 4 to the back cabinet 2b shown in FIG. 13, the locking claws for cabinet fixing 27a, which are the locking means of the fixing unit 20, are fitted into operation-section locking claws 40 formed in the back cabinet 2b, and locking stoppers 28 formed on the side portions of the locking claws for cabinet fixing 27a are locked to one end of the back cabinet 2b that forms the operation-section locking claws 40, whereby the button section 4 is fixed to the back cabinet 2b by using the fixing unit 20 (the condition shown in FIG. 14).

Next, as shown in FIG. 15, one end portion of the power-source circuit board 5a is supported in a sandwiched manner in the circuit-board fitting slits 15, 30 provided in the button section 4 and the fixing unit 20, which are guide grooves, and furthermore, the other end portion of this power-source circuit board 5a, which is other than the above-described one end portion, is locked to the first circuit-board locking claws 31 formed in the back cabinet 2b, whereby the power-source circuit board 5a is fixed to the button section 4 within the back cabinet 2b. Subsequently, edge portions of the main circuit board 5b are locked to the second circuit-board locking claws 32 formed in the back cabinet 2b, whereby also the main circuit board 5b is fixed to the interior of the back cabinet 2b.

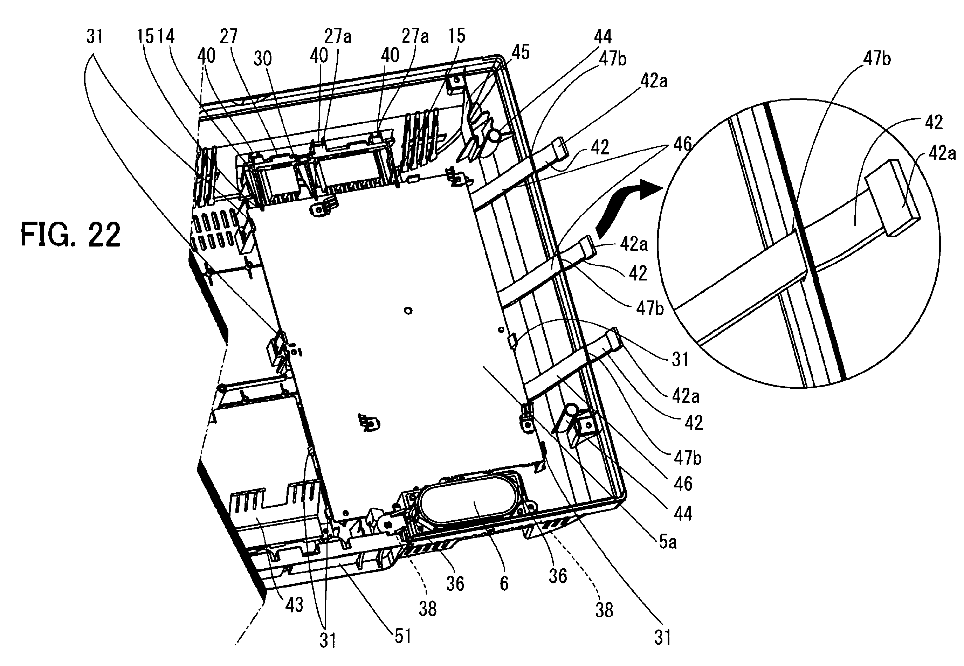

After the completion of the mounting and fixing of the power-source circuit board 5a and the main circuit board 5b, which are the above-described circuit boards, to the back cabinet 2b, the connection cable 42 provided in an extended condition from the power-source circuit board 5a is temporarily fixed. Reference numeral 46 denotes wire-holding ribs formed in the back cabinet 2b, and the wire-holding ribs 46 are formed to ensure that the two cables that constitute each of the connection cables 42 do not come together. Reference numeral 47a are temporary holding portions formed in the back cabinet 2b, which are notches, in order to lock the connection cables 42 when the connection cables 42 are disposed on both sides of the wire-holding ribs 46. Before the display panel 3 is placed, the temporary holding portions 47a are caused to temporarily clamp the connection cables 42. Incidentally, when the connection cable 42 is a cable in flat-plate form, such as a flat cable, and cannot be clamped by the temporary holding portion 47a in notch form, the temporary holding portion may be a through hole 47b as shown in FIG. 22 through which the connection cable 42 is inserted to temporarily hold the connection cable 42.

Next, the edge portions of the light-receiving board 5c are locked and fixed to light-receiving board locking claws 33 of the speaker holders 34 and the speakers 6 are locked and fixed to the speaker locking claws 36, and the cylindrical holes 38 formed in the speaker holders 34 to which the light-receiving board 5c and the speakers 6 are fixed, are inserted and fitted onto the boss portions 37 formed on the back cabinet 2b shown in FIG. 20, whereby the light-receiving board 5c and the speaker holders 34 to which the speakers 6 are fixed are fixed to the back cabinet 2b (the condition shown in FIG. 16).

Next, as shown in FIG. 3, the shield member 41 is fixed to a prescribed position of the back cabinet 2b and the grounding member 43 is fixed to a prescribed position of the main circuit board 5b. Subsequently, the mounting of the display panel 3 is performed. On that occasion, as shown in FIGS. 17 and 18, the display panel 3 is placed on the display panel standing holding portion 45 and the display panel supporting pieces 45b, 45c are caused to support the display panel 3 in a sandwiching manner, whereby the display panel 3 is supported in a standing manner, and wire connection work, such as connection of the connector 50a of the video signal transmission cable 50 to the connector 54 of the display panel 3, is performed. After that, the display panel 3 is detached from the display panel standing holding portion 45, and the display panel 3 is placed on the back cabinet 2b so as to be aligned with the display panel placement portion 44 in a position opposed to the shield member 41, the grounding member 43, the power-source circuit board 5a and the main circuit board 5b (the condition shown in FIG. 2). In this condition, the video signal transmission cable 50 is covered with the shield member 41 and the metal plate 48 covering the back surface of the display panel 3 and, therefore, noises generated from the video signal transmission cable 50 can be effectively shielded. Furthermore, because the grounding member 43 abuts similarly against the metal plate 48, the grounding of the main circuit board 5b can be performed simply by placing the display panel 3 in a prescribed position. With the display panel 3 placed on the back cabinet 2b so as to be aligned with the display panel placement portion 44, the connection cable 42 clamped by the temporary holding portion 47a is detached and the above-described connector 42a of the connection cable 42 is connected to the above-described connector 49 of the display panel 3. When the mounting and fixing of all electronic parts and circuit boards and the placement of the display panel 3 have been completed, the assembling step of the display device 1 is performed which involves assembling the front cabinet 2a to the back cabinet 2b as a unit. On that occasion, as shown in FIG. 19, the display panel 3 is held in a sandwiched manner and fixed by the front cabinet 2a and the back cabinet 2b and, therefore, it is unnecessary to fix the display panel 3 to the back cabinet 2b with screws and the like.

Next, on the basis of FIGS. 20 and 21 a description will be given of the step of mounting the leg portion 9 to the cabinet 2. The mounting portion 9a provided in the leg portion 9 is pierced through the leg-portion mounting hole 52 drilled in the leg-portion mounting portion 51 formed in the back cabinet 2b. Screws are inserted into the screw holes 9b drilled in the mounting portion 9a via leg-portion mounting screw holes 53 drilled in the back cabinet 2b, whereby the back cabinet 2b and the leg portion 9 are fixed together and the display device 1 shown in FIG. 1 is completed.

The display device 1 in this embodiment is provided in the interior of the cabinet whose depth dimension is small compared to the height and width dimensions, the cabinet 2 is provided with the operation section 10, part of which protrudes from the plurality of through holes 7 to outside the device, this operation section 10 is provided with the first holding means (circuit-board fitting slits 15, 30, which are guide grooves) that hold one end portion of the rectangular circuit board (power-source circuit board 5a)(the side of one of the four sides of the rectangular power-source circuit board 5a), the second holding means (first circuit-board locking claw 31), which holds at least the other end portions of the circuit board (power-source circuit board 5a)(the sides of the remaining three sides except the above-described one side) is provided in the cabinet 2, the circuit board (power-source circuit board 5a) held by the first holding means (circuit-board fitting slits 15, 30, which are guide grooves) and the second holding means (first circuit-board locking claw 31) are held substantially parallel to the display panel 3, the operation section 10 is composed of the button section 4, in which depressed portions protruding to outside the device are integrally formed, and the fixing unit 20, in which locking means (locking claws for cabinet fixing 27a, locking stoppers 28) in which this button section 4 is assembled to the back cabinet 2b of the cabinet 2 is formed, the power-source circuit board 5a is supported in a sandwiched manner by the circuit-board fitting slits 15 of the button section 4 as the guide grooves of the operation section 10 and the circuit-board fitting slits 30 of the fixing unit 20, and the power-source circuit board 5a is held by the first circuit-board locking claws 31 as the second holding means formed in the cabinet 2. As a result of this, the circuit board in which the switch 18 and the like are arranged (power-source circuit board 5a) can be held in a prescribed position by using the first holding means of the operation section 10 (circuit-board fitting slits 15, 30, which are guide grooves) and the second holding means provided in the back cabinet 2b of the cabinet 2 (first circuit-board locking claws 31), and it is possible to fix the circuit board (power-source circuit board 5a) without using screws unlike conventional display devices. Hence, in assembling the internal component parts, which are main parts of the display device 1, to the back cabinet 2b, the internal component parts, such as the speakers 6, the light-receiving board 5c and the power-source circuit board 5a, can be fixed by using the holding means and locking means (holding means) not by the fixing using screws and, therefore, complicated screwing work can be eliminated. Furthermore, because it is unnecessary to use metal screws, it is possible to reduce cost increases resulting from the use of metal materials. In addition, because the screwing work becomes unnecessary, it is possible to shorten the assembling work hours for assembling the internal component parts to the display device 1 and the manufacturing efficiency can be improved.

Moreover, the above-described second holding means is the first circuit-board locking claw 31, which is formed in quantities of one or two or more so as to extent from the inner surface side of the back cabinet to the opening thereof, and the other end portion of the power-source circuit board 5a, which is a circuit board, is locked by this first circuit-board locking claw 31. As a result of this, with the power-source circuit board 5a supported in a sandwiched manner by the guide grooves (circuit-board fitting slits 15, 30) as the first holding means of the operation section 10, it is possible to lock and hold the power-source circuit board 5a by using the first circuit-board locking claws 31 as the second holding means formed in the cabinet 2. Therefore, it is possible to readily fix the power-source circuit board 5a by the holding means alone without using screws.

Furthermore, because the speakers 6 and the light-receiving board 5c as the internal component parts are held by the third holding means (speaker holders 34) that do not use screws, it is possible to fix the speakers 6 and the light-receiving board 5c in prescribed positions within the back cabinet without using screws.

Moreover, the above-described third holding means is the speaker holders 34 provided with locking means for locking the speakers 6 and the light-receiving board 5c as the internal component parts (light-receiving board locking claws 33, speaker locking claws 36), and in the back cabinet 2b, the boss portions 37 are formed so as to extend from the inner surface side of this back cabinet 2b to the opening side thereof. Furthermore, the engagement holes 35 are formed in peripheral edge portions of the above-described opening of the back cabinet 2b in the vicinity of the boss portions 37, and the cylindrical holes 38 into which the boss portions 37 are fitted and the claw portions 39 that engage with the engagement holes 35 are formed in the above-described speaker holders 34. As a result of this, the internal component parts, such as the speakers 6 and the light-receiving board 5c, are locked by the speaker holders 34 as the third holding means, the cylindrical holes 38 of the speaker holders 34 are fitted onto the boss portions 37 of the back cabinet 2b, and the claw portions 39 formed in the speaker holders 34 are caused to engage with the engagement holes 35 of the back cabinet. Therefore, is possible to hold (fix) the speakers 6 and the light-receiving boards 5c, which are internal component parts, on the back cabinet 2b via the speaker holders 34 without using screws.

In other words, in the display device 1, all of the internal component parts as the main parts of this display device 1, i.e., the button section 4, the speakers 6 and the circuit boards (power-source circuit board 5a, main circuit board 5b, light-receiving board 5c) can be fixed by only holding means (fixing means) and the locking means formed in the holding means and the like without using metal screws, the button section 4 is fixed to the back cabinet 2b by using the locking claws for cabinet fixing 27a, locking stoppers 28 and the like as locking means, which are provided in the fixing unit 20, which is holding means separate from the button section 4, the circuit-board fitting slits 30 of the above-described fixing unit 20 alone or the circuit-board fitting slits 15, 30 formed in the fixing unit 20 and the button section 4 are caused to support the edge portions of the power-source circuit board 5a provided with the switch 18 in a sandwiching manner, whereby the power-source circuit board 5a and the button section 4 are fixed within the cabinet 2 (more specifically, within the back cabinet 2b) without using screw, and furthermore, the fixing unit 20 intended for fixing the button section 4 to the back cabinet 2b (more specifically, the circuit-board fitting slit 30 of the fixing unit 20) or the button section 4 intended for manually operating the display device 1 in addition to this fixing unit 20 is caused to serve also as means for holding (fixing) the power-source circuit board 5a. As a result of this, it is possible to readily perform the fixing of the power-source circuit board 5a and the button section 4 simply by performing locking without using screws unlike conventional display devices and it is possible to eliminate complicated work, such as screwing work of each component. In addition, because it is unnecessary to use metal screws, it is possible to reduce cost increases resulting from the use of metal materials.

Furthermore, the edge portions of the power-source circuit board 5a are supported in a sandwiched manner in the circuit-board fitting slits 15, 30 formed in the fixing unit 20 and the button section 4, the edge portions of the power-source circuit board 5a are locked to the first
circuit-board locking claws 31 integrally formed in the back cabinet 2b, which are holding (locking) means, and the power-source circuit board 5a is fixed to the interior of the cabinet 2, whereby the three parts of power-source circuit board 5a, fixing unit 20 and button section 4 are mutually integrated together. Therefore, it is possible to hold these three parts in a condition in which these parts are positioned so that they are not displaced from each other.

Furthermore, the speakers 6 capable of outputting sounds in response to video images displayed on the display panel 3 placed on the back cabinet 2b side of the display device 1 can be fixed simply by being locked to the speaker locking claws 36 provided within the cabinet 2, which are locking means of the speaker holders 34 without using screws, and therefore, it is possible to readily perform the mounting of the speakers 6 by one-touch operation. Hence, it is possible to improve the efficiency of assembling work and by extension, it is possible to improve the production efficiency of the display device 1.

In performing the wire connection work of the power-source circuit board 5a, main circuit board 5b, speakers 6 and the like mounted on the back cabinet 2b to the display panel 3 with the aid of the display panel standing holding portion 45 capable of holding the display panel 3 in a standing position, for example, the work of connecting the connector 50a of the video signal transmission cable 50 and the like to the connector 54 of the display panel 3 becomes exceedingly easy compared to a method that involves mounting the display panel 3 to the front cabinet as in conventional methods of manufacturing liquid-crystal display devices. Also, because special equipment and materials for causing the display panel 3 to stand are unnecessary and integral forming is possible in the injection molding of the back cabinet 2b, the display device 1 can be realized at low cost. Furthermore, because during the performance inspection and maintenance of the display device 1 the display panel 3 can be held in a standing manner, with wires kept connected, the display device 1 is also excellent in workability in performance inspection, maintenance and the like. Furthermore, the temporary holding portion 47a of the connection cable 42 is formed in the back cabinet 2b. Therefore, in placing the display panel 3, this prevents the connection cable 42 and the connector 42a from being pinched between the back cabinet 2b and the display panel 3 and from slipping down into gaps between the power-source circuit board 5a and the back cabinet 2b, and it is possible to substantially improve the workability at low cost.

According to the above-described manufacturing method of the display device 1, main electronic parts, such as the display panel 3, the button section 4, the speakers 6 and the circuit boards 5a, 5b, 5c, can be housed in the back cabinet 2b. As a result of this, because in the manufacture of the display device 1, the back cabinet 2b is placed on a flat surface of a workbench and the like, each part is mounted to the back cabinet and wire connection work can be performed by holding the display panel 3 in a standing manner, the work efficiency is remarkably improved. Furthermore, because the display surface of the display panel 3 is not turned downward during the work, the possibility that the display surface of the display panel 3 is damaged does not exist any more. Also during the performance inspection of the display device 1 and maintenance work thereof due to failures and the like, because main electronic parts are housed within the back cabinet 2b, the functions of the display device are not lost even when the front cabinet 2a is detached and it becomes easy to grasp the performance inspection and failure condition of each electronic part. Thus, the display unit is excellent in workability. Also because the shape of the shield member 41 can be selected according to the shape of parts from which noises may be generated, the size of the metal plate constituting the shield member 41 can be a necessary and sufficient one. Thus, the manufacturing cost can be reduced.

Although the embodiment of the present invention was described above, the present invention is not limited by the above-described embodiment but various modifications are possible in the scope of the gist of the invention. For example, there is no problem in the least if the quantity and shape of each locking claw are appropriately changed according to the stiffness of the resin, the size of parts to be fixed and the like. Although the display panel 3 is a liquid-crystal panel, there is no problem in the least if the display device uses a panel other than a liquid-crystal panel, such as an organic EL display using a substance which emits light by the application of voltage and a plasma display that emits light by applying a high voltage to a high-pressure rare gas. In the manufacture of a display device not provided with speakers, for example, a monitor for a personal computer, the manufacturing method of the present invention can be readily applied by omitting portions related to the speakers from the procedure described in the above-described embodiment. In a display device provided with a recording and reproducing device, such as a thin-screen television receiving set in which a DVD recording and reproducing device is incorporated, the recording and reproducing device is mounted to the back cabinet 2b, whereby the balance of the load applied to the back cabinet 2b produced during the holding of the display panel 3 in a standing manner becomes improved.

The effects of the present invention are as follows.

According to the constitution of the present invention described above, a display device can be manufactured by placing the back cabinet on a flat surface of a workbench, for example, mounting the operation button, circuit board and other electronic parts to the back cabinet, placing the display panel, and fixing the display panel by sandwiching the display panel by use of the front cabinet. That is, because main parts can be mounted to only the back cabinet, and not mounted to the front cabinet, it is necessary only that the work be carried out by paying attention to one of the two types of cabinets, which are relatively large members. Therefore, it is possible to provide a display device that is excellent in workability in manufacture and maintenance.

## Claims

1. A display device that is provided with internal component parts and a display panel within a cabinet formed by assembling an opening of a front cabinet and an opening of a back cabinet,
wherein within the back cabinet, a mounting portion for mounting an operation button as one of the internal component parts, a mounting portion for mounting a circuit board as one of the internal component parts, a mounting portion for mounting a speaker for audio output as one of the internal component parts, and a mounting portion for mounting a recording and reproducing device as one of the internal component parts are formed each with respect to the back cabinet, and
wherein a placement portion for placing the display panel is integrally formed as a boss from the back cabinet.

2. A display device that is provided with internal component parts and a display panel within a cabinet formed by assembling an opening of a front cabinet and an opening of a back cabinet,
wherein within the back cabinet, a mounting portion for mounting an operation button as one of the internal component parts, a mounting portion for mounting a circuit board as one of the internal component parts, and a mounting portion for mounting a speaker for audio output as one of the internal components parts are formed each with respect to the back cabinet,
wherein a placement portion for placing the display panel is integrally formed as a boss from the back cabinet, and
wherein a display panel standing holding portion for holding the display panel placed on the placement portion in a standing manner is provided.

3. A display device that is provided with internal component parts and a display panel within a cabinet formed by assembling an opening of a front cabinet and an opening of a back cabinet,
wherein within the back cabinet, a mounting portion for mounting an operation button as one of the internal component parts, a mounting portion for mounting a circuit board as one of the internal component parts, and a mounting portion for mounting a speaker for audio output as one of the internal component parts, and a mounting portion for mounting a recording and reproducing device as one of the internal component parts are formed each with respect to the back cabinet,
wherein a placement portion for placing the display panel is integrally formed as a boss from the back cabinet, and
wherein a display panel standing holding portion for holding the display panel placed on the placement portion in a standing manner is provided.

4. The display device according to any one of claims 1 to 3, wherein a back surface of the display panel is formed from a metal plate, a grounding member having a plate spring portion is mounted to the circuit board, and the plate spring portion of the grounding member comes into contact with the back surface of the display panel when the display panel is placed on the placement portion.

5. The display device according to any one of claims 1 to 4, wherein a shield member is mounted in places of the circuit board where noises are generated, whereby the effect of noises by the circuit board is suppressed.
